# EUROPÄISCHE PATENTSCHRIFT

(11) **EP 2 728 613 B1**
(45) Veröffentlichungstag und Bekanntmachung des Hinweises auf die Patenterteilung: **03.06.2015**
(21) Anmeldenummer: 12191259.6
(22) Anmeldetag: 05.11.2012
(51) Int. Cl.: H01L 23/00, B23K 20/00, B23K 31/12

(54) **Verfahren zur Prüfung einer Drahtbondverbindung**
Method for testing a wire bond joint
Procédé destiné à la vérification d'une connexion filaire

(43) Veröffentlichungstag der Anmeldung: 07.05.2014
(73) Patentinhaber: Smartrac IP B.V., 1077 XX Amsterdam (NL)
(72) Erfinder: Michalk, Manfred, Dr., 99092 Erfurt (DE); Oehring, Martina, 99891 Tabarz (DE)
(74) Vertreter: advotec.

(56) Entgegenhaltungen:
- EP-A1- 1 310 319
- EP-A1- 2 189 235
- DE-A1- 19 752 319
- JP-A- H04 245 451
- JP-A- 2011 181 643
- US-A1- 2010 181 367

## Beschreibung

Die vorliegende Erfindung betrifft ein Verfahren zur Prüfung einer mittels eines Bondwerkzeugs hergestellten Drahtbondverbindung zwischen einem Bonddraht und einer Kontaktfläche eines Substrats, wobei der Bonddraht während oder unmittelbar nachfolgend der Herstellung der Drahtbondverbindung mit einer an einer Drahtführungseinrichtung angeordneten oder einer zusammen mit einer Drahtführungsbewegung der Drahtführungseinrichtung bewegten Drahtklemme gehalten wird.

Ein Verfahren dieser Art ist aus der DE 19752319 A1 bekannt.

Aus der EP 1 310 319 A1 ist ein Prüfverfahren der eingangs genannten Art bekannt, bei dem nach Herstellung einer Drahtbondverbindung zwischen einem Bonddraht und einer Kontaktfläche eines Substrats die Drahtbondverbindung mit einer definierten Zugkraft belastet wird. Hierzu wird der Bonddraht mittels einer Drahtklemme erfasst und anschließend um eine Strecke angehoben, die derart berechnet ist, dass durch das Anheben eine vorbestimmte Zugkraft erzeugt wird. Die Zugkraft wird während der Bewegung kontinuierlich gemessen.

Da bei dem bekannten Verfahren der Bonddraht von der Drahtklemme fest ergriffen und die Zugkraft zur Prüfung der Drahtbondverbindung in Abhängigkeit von der Wegstrecke erzeugt wird, ist mit der Durchführung des bekannten Prüfverfahrens eine Unterbrechung der Drahtführungsbewegung erforderlich, die zur Herstellung einer Drahtverbindung zwischen einer ersten Kontaktfläche und einer zweiten Kontaktfläche ausgeführt wird. Hierdurch ergibt sich eine Unterbrechung der ansonsten, also bei Verzicht auf Durchführung einer Prüfung der Drahtbondverbindung, kontinuierlich ausgeführten Drahtführungsbewegung mit einer entsprechenden Verlängerung der zur Herstellung einer Drahtverbindung zwischen den Kontaktflächen benötigten Zeit.

Der vorliegenden Erfindung liegt die Aufgabe zugrunde, ein Verfahren zur Prüfung einer Drahtbondverbindung vorzuschlagen, das ohne Beeinträchtigung der Herstellung der Drahtverbindung ausführbar ist.

Zur Lösung dieser Aufgabe weist das erfindungsgemäße Verfahren die Merkmale des Anspruchs 1 auf.

Erfindungsgemäß wird der Bonddraht während der Drahtführungsbewegung mit definierter Schließkraft in der Drahtklemme gehalten, wobei die Größe der Schließkraft so gewählt wird, dass bei Erreichen einer definierten Zugkraft im Bonddraht und Fortsetzung der Drahtführungsbewegung zwischen Klemmflächen der Drahtklemme und einer Drahtoberfläche des Bonddrahts ein Wechsel von Haftreibung zu Gleitreibung erfolgt und der Bonddraht durch die Drahtklemme gleitet.

Bei dem erfindungsgemäßen Verfahren kann der Bonddraht also durch die Drahtklemme hindurch gleiten, wenn die definierte maximale Zugkraft die aufgrund der Schließkraft in der Drahtklemme ausgebildete Haltekraft der Drahtklemme überschreitet, so dass nach Überschreitung der Haltekraft der Drahtklemme bei einer Fortführung der Drahtführungsbewegung der Bonddraht mit einer nunmehr geringeren Zugkraftbelastung durch die Drahtklemme gleitet. Wenn die Zugkraft die Haltekraft der Drahtklemme überschreitet, erfolgt demnach zwischen Klemmflächen der Drahtklemme und einer Drahtoberfläche des Bonddrahts ein Wechsel von Haftreibung zu Gleitreibung.

Aus dem Vorstehenden ergibt sich, dass das erfindungsgemäße Verfahren eine Prüfung der Drahtbondverbindung ohne Unterbrechung der Drahtführungsbewegung ermöglicht, die zur Herstellung einer Drahtverbindung zwischen zwei Kontaktflächen ausgeführt wird. Hierdurch ist es möglich, die Drahtverbindung zwischen den Kontaktflächen trotz der gleichzeitig mit Herstellung jeder Drahtbondverbindung zwischen dem Bonddraht und den Kontaktflächen ausgeführten Prüfung in derselben Zeit auszuführen, wie eine Drahtverbindung, bei der keine Prüfung der Drahtbondverbindungen stattfindet.

Besonders vorteilhaft ist es, wenn die Drahtklemme längs der gesamten Drahtführungsstrecke von einer ersten Drahtbondverbindung zwischen dem Bonddraht und einer ersten Kontaktfläche bis zu einer zweiten Drahtbondverbindung zwischen dem Bonddraht und einer zweiten Kontaktfläche eine kontinuierliche Bewegung ausführt, so dass Zugspannungsschwankungen im Draht und damit mögliche Schwingungserregungen im Bonddraht weitestgehend vermieden werden.

Wenn darüber hinaus die Bewegung der Drahtklemme zwischen den Drahtbondverbindungen mit konstanter Geschwindigkeit erfolgt, kann die Ausbildung von auf den Bonddraht wirkenden Massenkräften abgesehen von Beschleunigungs- bzw. Bremskräften unmittelbar nach Herstellung der ersten Drahtbondverbindung und unmittelbar vor Herstellung der zweiten Drahtbondverbindung im Wesentlichen vollständig vermieden werden.

Eine besonders den Bonddraht schonende Herstellung der Drahtbondverbindungen bzw. die Ausbildung definierter Bonddrahtschleifen bei der Herstellung der Drahtverbindung zwischen zwei Kontaktflächen wird möglich, wenn nach Ausbildung der Gleitreibung zwischen der Drahtklemme und dem Bonddraht eine Reduzierung der Schließkraft der Drahtklemme erfolgt, so dass bei Bedarf die von der Drahtklemme auf den Bonddraht wirkende Bremswirkung reduziert oder an die gewünschte Drahtführung bzw. Ausbildung der Drahtverbindung angepasst werden kann.

Insbesondere ist es möglich, die Schließkraft so weit zu reduzieren, dass während der Drahtführungsbewegung längs der Drahtführungsstrecke der Bonddraht mit immer noch definierter Zugkraftbelastung jedoch erheblich reduzierter Bremswirkung durch die Drahtklemme gleitet.

Besonders vorteilhaft ist es auch, wenn die beim Wechsel von Haftreibung zu Gleitreibung im Bonddraht erreichte Zugkraft zumindest stichprobenartig gemessen und bei Ermittlung von außerhalb eines Zugkrafttoleranzbereichs liegenden Werten der Zugkraft eine entsprechende Änderung der Schließkraft der Drahtklemme erfolgt. Beispielsweise kann lediglich bei jeder zehnten oder hundertsten Drahtbondverbindung eine Zugkraftmessung vorgenommen werden, um für den Fall, dass außerhalb des Zugkrafttoleranzbereichs liegende Zugkraftwerte festgestellt werden, eine Erhöhung oder Reduzierung der Schließkraft der Drahtklemme vorzunehmen, so dass bei nachfolgenden Drahtbondverbindungen wieder eine Zugkraft erreicht wird, die innerhalb des Zugkrafttoleranzbereichs liegt.

Hierdurch wird insbesondere die Möglichkeit geschaffen, Veränderungen des Reibungskoeffizienten zwischen den Klemmflächen der Drahtklemme und der Drahtoberfläche des Bonddrahts, die beispielsweise aufgrund von Bonddrahtablagerungen auf den Klemmflächen entstehen können, zu kompensieren.

Nachfolgend werden bevorzugte Varianten des Verfahrens sowie dabei zum Einsatz kommende Vorrichtungen anhand der Zeichnungen näher erläutert.

Es zeigen:
- **Fig. 1**: eine zur Durchführung des Verfahrens geeignete Drahtbondvorrichtung in einer ersten Ausführungsform;
- **Fig. 2**: eine zur Durchführung des Verfahrens geeignete Drahtbondvorrichtung in einer zweiten Ausführungsform;
- **Fig. 3**: eine Ultraschallbondvorrichtung mit einem als Ultraschallbonder ausgeführten Bondwerkzeug während der Herstellung einer Drahtbondverbindung;
- **Fig. 4**: die in **Fig. 3** dargestellte Drahtbondvorrichtung mit geschlossener Drahtklemme nach Streckung des Bonddrahts;
- **Fig. 5**: die in **Fig. 3** dargestellte Drahtbondvorrichtung mit geschlossener Drahtklemme nach Überschreiten der Haftgrenze;
- **Fig. 6**: die in **Fig. 3** dargestellte Drahtbondvorrichtung mit geöffneter Drahtklemme.

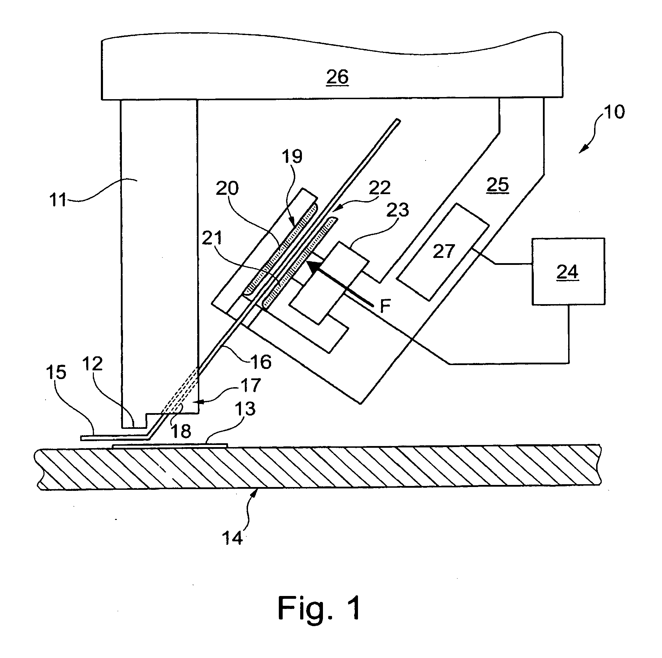

**Fig. 1** zeigt eine Drahtbondvorrichtung 10 mit einem Bondwerkzeug 11, das im vorliegenden Fall als Ultraschallbonder mit einem Stempel ausgeführt ist, der durch einen hier nicht näher dargestellten Ultraschallwandler zu Schwingungen angeregt wird. Zwischen einer am unteren Ende des Bondwerkzeugs 11 ausgebildeten Bondfläche 12 und einer Kontaktfläche 13 eines Substrats 14 ist ein freies Drahtende 15 eines Bonddrahts 16 angeordnet. Zur definierten Ausführung einer Drahtführungsbewegung längs einer definierten Drahtführungsstrecke ist das Bondwerkzeug 11 mit einer Drahtführungseinrichtung 17 versehen, die im vorliegenden Fall durch einen im Bondwerkzeug 11 benachbart der Bondfläche 12 ausgebildeten Führungskanal 18 gebildet ist.

Wie weiterhin der **Fig. 1** zu entnehmen ist, ist der Bonddraht 16 im Anschluss an die Drahtführungseinrichtung 17 durch eine Drahtklemme 19 geführt, die bewegungsgekoppelt mit dem Bondwerkzeug 11 ausgebildet ist und hierzu bei dem dargestellten Ausführungsbeispiel zusammen mit dem Bondwerkzeug 11 in einem gemeinsamen Bondkopf 26 angeordnet ist.

Die Drahtklemme 19 weist im vorliegenden Fall zwei Klemmenbacken 20 und 21 auf, die durch einen Klemmenspalt 22, durch den der Bonddraht 16 hindurchgeführt ist, beabstandet sind. Zur Ausführung einer Schließbewegung bzw. Ausbildung einer auf den Bonddraht 16 wirkenden Schließkraft F ist bei dem in **Fig. 1** dargestellten Ausführungsbeispiel die Klemmenbacke 21 mit einem Klemmenantrieb 23 versehen, der beispielsweise als Piezoantrieb oder Tauchspulenantrieb ausgebildet sein kann und von einer Klemmensteuerung 24 gesteuert wird. Die Drahtklemme 19 ist im vorliegenden Fall über einen Klemmenhalter 25, der mit einem beispielsweise als Dehnungsmessstreifen ausgebildeten Kraftsensor 27 versehen ist, an den Bondkopf 26 angeschlossen. Der Kraftsensor 27 ist mit der Klemmensteuerung 24 über eine Signalleitung verbunden.

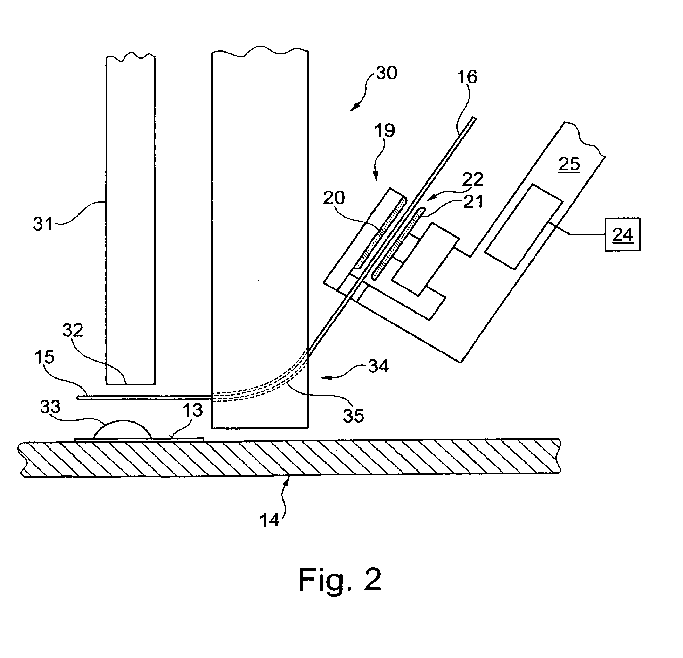

**Fig. 2** zeigt in einer alternativen Ausführungsform eine Drahtbondvorrichtung 30, die übereinstimmend mit der in **Fig. 1** dargestellten Drahtbondvorrichtung 10 eine über einen Klemmenhalter 25 mit einem Bondkopf 26 verbundene Drahtklemme 19 aufweist.

Im Unterschied zu der in **Fig.** 1 dargestellten Drahtbondvorrichtung 10 weist die Drahtbondvorrichtung 30 ein Bondwerkzeug 31 auf, das als Lötkolben ausgebildet ist, der mit einer an seinem unteren Ende angeordneten Bondfläche 32 zur Ausführung eines Lötvorgangs gegen das Drahtende 15 des Bonddrahts 16 zur Anlage gebracht werden kann, wobei zur Herstellung einer als Lötverbindung ausgeführten Drahtbondverbindung auf der Kontaktfläche 13 des Substrats 14 ein Lotdepot 33 angeordnet ist.

Unmittelbar benachbart der Bondfläche 32 befindet sich eine Drahtführungseinrichtung 34 mit einem am unteren Ende der Drahtführungseinrichtung 34 ausgebildeten Drahtführungskanal 35, durch den der Bonddraht 16 hindurchgeführt ist, der in seinem weiteren Verlauf, wie bereits Bezug nehmend auf die Drahtbondvorrichtung 10 in **Fig. 1** beschrieben, durch den Klemmenspalt 22 der Drahtklemme 19 geführt ist.

Ergänzend zu den in den **Fig. 1** **und** **2** dargestellten Drahtbondvorrichtungen 10 bzw. 30 wird betont, dass abweichend von der in den Figuren von der Drahtführungseinrichtung 17 bzw. 34 unabhängigen Ausgestaltung der Drahtklemme 19 es auch möglich ist, die Drahtführungseinrichtung und die Drahtklemme in eine Vorrichtungskomponente integriert auszuführen, also beispielsweise die Drahtführungseinrichtung in die Drahtklemme zu integrieren. Beispielsweise ist dies möglich durch die Ausbildung eines Führungskanals in dem in den **Fig. 1** **und** **2** als unbewegliche Klemmenbacke 20 ausgeführten Bereich der Drahtklemme 19.

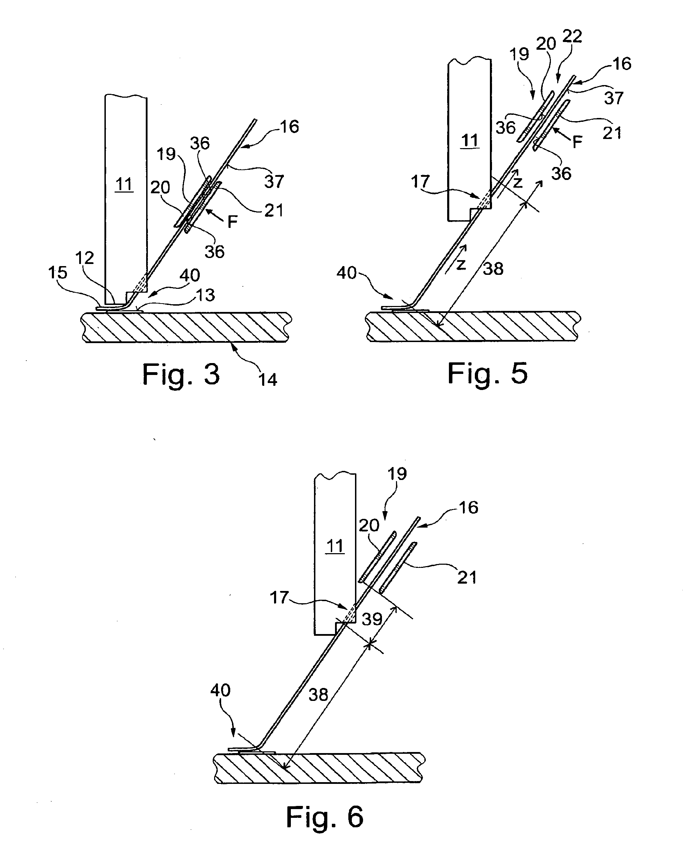

Nachfolgend wird am Beispiel der in **Fig. 1** dargestellten Drahtbondvorrichtung 10 die Herstellung einer Drahtbondverbindung mit nachfolgender Prüfung der Drahtbondverbindung Bezug nehmend auf die **Fig. 3 bis 5** näher erläutert.

**Fig. 3** zeigt, wie zur Herstellung eines Drahtkontakts 40 zwischen dem Drahtende 15 des Bonddrahts 16 und der Kontaktfläche 13 des Substrats 14 das Drahtende 15 mittels der Bondfläche 12 des Bondwerkzeugs 11 gegen die Kontaktfläche 13 gedrückt und mit Ultraschallschwingungen des Bondwerkzeugs 11 beaufschlagt wird. Während der Herstellung des Drahtkontakts 40 ist bei der in **Fig. 3** dargestellten Kontaktierung die Drahtklemme 19 geschlossen, so dass über Klemmflächen 36 der Klemmenbacken 20, 21 eine Drahtoberfläche 37 des Bonddrahts 16 mit der Schließkraft F beaufschlagt wird.

Die Schließkraft F ist so bemessen, dass unter Berücksichtigung des zwischen den Klemmflächen 36 und der Drahtoberfläche 37 gegebenen Reibungskoeffizienten, der im Wesentlichen von der Oberflächenbeschaffenheit der Klemmflächen 36 und der Drahtoberfläche 37 bestimmt ist, bei Ausübung einer Zugbelastung eine definierte maximale Zugkraft Z erreicht wird, bevor bei geschlossener Drahtklemme 19 und fortgesetzter Bewegung der Drahtklemme 19 längs der Drahtführungsstrecke der Bonddraht 16 durch die Drahtklemme 19 gleitet.

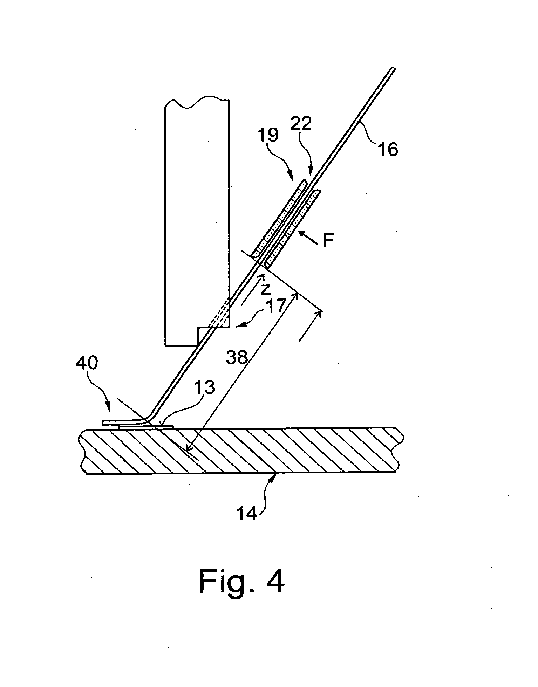

**Fig. 4** zeigt die Beaufschlagung des Drahtkontakts 40 durch die Zugkraft FZ in Folge einer Bewegung der geschlossenen Drahtklemme 19 zusammen mit der Führungseinrichtung 17. Die Bewegung der Drahtklemme 19 erfolgt dabei kontinuierlich, wobei nach einer ersten Teilstrecke 38, deren Länge nach Streckung des Bonddrahts 16 durch die Haftgrenze der Klemmenbacken 20, 21 an der Drahtoberfläche 37 des Bonddrahts 16 bestimmt ist, die maximale Zugkraft Z erreicht ist. Die Schließkraft F der Drahtklemme 19 ist so gewählt, dass die Haftgrenze erst dann erreicht wird, wenn die vorgegeben maximale Zugkraft Z an der Kontaktstelle 40 anliegt. Die Zugkraft Z kann mittels des in **Fig. 1** dargestellten Kraftsensors 27 erfasst werden.

Wie in **Fig. 5** dargestellt, erfolgt nach Überschreiten der Haftgrenze und Fortsetzung der Bewegung in der zwischen den Klemmenflächen 36 der Klemmenbacken 20, 21 und der Drahtoberfläche 37 des Bonddrahts 16 gebildeten Reibkontaktfläche ein Wechsel von Haftreibung zu Gleitreibung, so dass der Bonddraht 16 bei unveränderter Schließkraft F beginnt durch den Klemmenspalt 22 zu gleiten. In Folge des Gleitens sinkt die auf die Drahtbondverbindung wirkende Zugkraft Z ab.

Wie **Fig. 6** zeigt, kann, wenn die Drahtklemme 19 bzw. das mit der Drahtführungseinrichtung 17 versehene Bondwerkzeug 11 eine definierte Gleitstrecke 39 zurückgelegt hat, die Schließkraft F reduziert oder die Drahtklemme 19 geöffnet werden, um die Drahtführungsbewegung mit geringerer Zugkraftbelastung des Bonddrahts 16 bzw. des Drahtkontakts 40 ausführen zu können, ohne dass die kontinuierliche Bewegung der Drahtklemme 19 bzw. des mit der Drahtführungseinrichtung 17 versehenen Bondwerkzeugs 11 unterbrochen werden muss.

Wenn sich das Drahtende 15 in Folge einer auf die Kontaktstelle 40 ausgeübten Zugkraft Z von der Kontaktfläche 13 löst, wird der über die definierte Schließkraft F vorgegebene Zugkraft Z nicht erreicht, so dass das Ausgangssignal des Kraftsensors 27 nicht den definierten Sollwert erreicht und ein Kontaktierungsfehler festgestellt wird. In diesem Fall kann die Drahtklemme 19 geschlossen bleiben, um ein Ausfädeln des Bonddrahts 16 aus der Drahtklemme 19 zu vermeiden.

Aus den vorstehenden Ausführungen wird deutlich, dass das erfindungsgemäße Prüfverfahren ein stetiges und schwingungsarmes, ruckfreies Bewegen der Drahtführungseinrichtung bzw. des Bondwerkzeugs ermöglicht, wobei Zugprüfwinkel und Zugprüfwerte für jeden Drahtkontakt individuell vorgegeben werden können.

## Patentansprüche

1. Verfahren zur Prüfung einer mittels eines Bondwerkzeugs (11, 31) hergestellten Drahtbondverbindung (40) zwischen einem Bonddraht (16) und einer Kontaktfläche (13) eines Substrats (14), wobei der Bonddraht während oder unmittelbar nachfolgend der Herstellung der Drahtbondverbindung mit einer an einer Drahtführungseinrichtung (17, 34) angeordneten oder mit einer zusammen mit der Drahtführungsbewegung der Drahtführungseinrichtung bewegten Drahtklemme (19) gehalten wird,
**dadurch gekennzeichne**t,
dass der Bonddraht während der Drahtführungsbewegung mit definierter Schließkraft F in der Drahtklemme gehalten wird, wobei die Größe der Schließkraft F so gewählt wird, dass bei Erreichen einer definierten Zugkraft Z im Bonddraht und Fortsetzung der Drahtführungsbewegung zwischen Klemmflächen (36) der Drahtklemme und einer Drahtoberfläche (37) des Bonddrahts ein Wechsel von Haftreibung zu Gleitreibung erfolgt und der Bonddraht durch die Drahtklemme gleitet.

2. Verfahren nach Anspruch 1,
**dadurch gekennzeichnet,**
**dass** die Drahtklemme (19) längs einer Drahtführungsstrecke von einer ersten Drahtbondverbindung (40) zwischen dem Bonddraht (16) und einer ersten Kontaktfläche (13) bis zu einer zweiten Drahtbondverbindung zwischen dem Bonddraht und einer zweiten Kontaktfläche eine kontinuierliche Bewegung ausführt.

3. Verfahren nach Anspruch 2,
**dadurch gekennzeichnet,**
**dass** die Bewegung der Drahtklemme (19) zwischen den Drahtbondverbindungen mit konstanter Geschwindigkeit erfolgt.

4. Verfahren nach einem der vorangehenden Ansprüche,
**dadurch gekennzeichnet,**
**dass** nach Ausbildung der Gleitreibung zwischen der Drahtklemme (19) und dem Bonddraht (16) eine Reduzierung der Schließkraft F erfolgt.

5. Verfahren nach Anspruch 4,
**dadurch gekennzeichnet,**
**dass** die Schließkraft F soweit reduziert wird, dass während der Drahtführungsbewegung längs der Drahtführungsstrecke der Bonddraht (16) mit definierter Zugkraft durch die Drahtklemme (19) gleitet.

6. Verfahren nach einem der vorangehenden Ansprüche,
**dadurch gekennzeichnet,**
**dass** die beim Wechsel von Haftreibung zu Gleitreibung im Bonddraht (16) erreichte Zugkraft Z zumindest stichprobenartig gemessen und bei Ermittlung von außerhalb eines Zugkrafttoleranzbereichs liegenden Werten der Zugkraft Z eine entsprechende Änderung der Schließkraft F erfolgt.

## Claims

1. A method for testing a wire bond joint (40) having been produced with the aid of a bonding tool (11, 31) between a bonding wire (16) and a contact surface (13) of a substrate (14), wherein the bonding wire, during or immediately subsequently to the production of the wire bond joint, is held with the help of a wire clamp (19) being disposed at a wire guide unit (17, 34) or with the help of a wire clamp (19) being moved together with the guide movement of the wire guide unit,
**characterised in that**
the bonding wire, during the wire guide movement, is held in the wire clamp with a defined closing force F, the size of the closing force F being selected such that, when a defined tractive force Z is reached in the bonding wire and when the wire guide movement is continued, between clamping surfaces (36) of the wire clamp and a wire surface (37) of the bonding wire, a changeover from static friction to sliding friction is effected and the bonding wire slides through the wire clamp.

2. The method according to claim 1,
**characterised in that**
the wire clamp (19) performs a continuous movement along a wire guide path from a first wire bond joint (40) between the bonding wire (16) and a first contact surface (13) up to a second wire bond joint between the bonding wire and a second contact surface.

3. The method according to claim 2,
**characterised in that**
the movement of the wire clamp (19) between the wire bond joints is effected with a constant speed.

4. The method according to one of the preceding claims,
**characterised in that,**
after the sliding friction has been established between the wire clamp (19) and the bonding wire (16), the closing force F is reduced.

5. The method according to claim 4,
**characterised in that**
the closing force F is reduced to such an extent that, during the wire guide movement along the wire guide path, the bonding wire (16) slides through the wire clamp (19) with a defined tractive force.

6. The method according to one of the preceding claims,
**characterised in that**
at least random measurements are taken of the tractive force Z having been reached during the changeover from static friction to sliding friction in the bonding wire (16) and **in that**, if values of the tractive force Z that are not within a tractive force tolerance range are identified, the closing force F is changed correspondingly.

## Revendications

1. Procédé destiné à l'examen d'une liaison filaire (40) ayant été fabriquée à l'aide d'un outil (11, 31) de liaison entre un fil (16) de liaison et une surface (13) de contact d'un substrat (14), dans lequel le fil de liaison, pendant ou immédiatement subséquemment à la fabrication de la liaison filaire, est maintenu avec un serre-fil (19) étant disposé à une unité (17, 34) de guidage de fil ou avec un serre-fil (19) étant mu concurremment avec le mouvement de guidage de l'unité de guidage de fil,
**caractérisé en ce que**
le fil de liaison, pendant le mouvement de guidage de fil, est maintenu dans le serre-fil avec une force de serrage F définie, la grandeur de la force de serrage F étant sélectionnée de façon que, quand une force de traction Z définie est atteinte dans le fil de liaison et quand le mouvement de guidage de fil continue, entre des surfaces (36) de serrage du serre-fil et une surface (37) filaire du fil de liaison, un changement de frottement par adhérence à frottement de glissement se produit et le fil de liaison glisse à travers le serre-fil.

2. Procédé selon la revendication 1,
**caractérisé en ce que**
le serre-fil (19) exécute un mouvement continu le long d'un trajet de guidage de fil d'une première liaison filaire (40) entre le fil (16) de liaison et une première surface (13) de contact jusqu'à une deuxième liaison filaire entre le fil de liaison et une deuxième surface de contact.

3. Procédé selon la revendication 2,
**caractérisé en ce que**
le mouvement du serre-fil (19) entre les liaisons filaires est exécuté avec une vitesse constante.

4. Procédé selon l'une quelconque des revendications précédentes,
**caractérisé en ce que**
la force de serrage F est réduite après l'établissement du frottement de glissement entre le serre-fil (19) et le fil (16) de liaison.

5. Procédé selon la revendication 4,
**caractérisé en ce que**
la force de serrage F est réduite au point que, pendant le mouvement de guidage de fil le long du trajet de guidage de fil, le fil (16) de liaison glisse à travers le serre-fil (19) avec une force de traction définie.

6. Procédé selon l'une quelconque des revendications précédentes,
**caractérisé en ce que**
la force de traction F ayant été atteinte pendant le changement de frottement par adhérence à frottement de glissement dans le fil (16) de liaison est mesurée au moins par sondages, et **en ce que** la force de serrage F est modifiée de façon correspondante si des valeurs de la force de traction Z qui sont hors d'une marge de tolérance de la force de traction sont identifiées.
